# EUROPEAN PATENT SPECIFICATION

(11) **EP 1 259 981 B1**
(45) Date of publication and mention of the grant of the patent: **10.08.2011**
(21) Application number: 00946518.8
(22) Date of filing: 30.06.2000
(51) Int. Cl.: H01L 21/56

(54) **DEVICE AND METHOD FOR ENCAPSULATING ELECTRONIC COMPONENTS MOUNTED ON A CARRIER**
ANORDNUNG UND VERFAHREN ZUM EINKAPSELN ELEKTRONISCHER KOMPONENTEN MONTIERT AUF EINEM TRÄGER
DISPOSITIF ET PROCEDE D'ENCAPSULATION DE COMPOSANTS ELECTRONIQUES MONTES SUR UN SUPPORT

(30) Priority: 01.07.1999 NL 1012488
(43) Date of publication of application: 27.11.2002
(73) Proprietor: FICO B.V., 6921 RW Duiven (NL)
(72) Inventor: PETERS, Hendrikus, Johannes, Bernardus, NL-6942 GP Didam (NL); VERMEULEN, Richard, Theodorus, NL-6863 CN Arnhem (NL)
(74) Representative: Van den Heuvel, Henricus Theodorus
(86) International application number: PCT/NL2000/000458
(87) International publication number: WO 2001/017012

(56) References cited:
- EP-A- 0 692 820
- GB-A- 2 266 856
- NL-A- 9 401 682
- US-A- 4 954 308
- PATENT ABSTRACTS OF JAPAN vol. 006, no. 226 (E-141), 11 November 1982 (1982-11-11) -& JP 57 128930 A (YAMAGATA NIPPON DENKI KK), 10 August 1982 (1982-08-10)
- PATENT ABSTRACTS OF JAPAN vol. 016, no. 499 (E-1280), 15 October 1992 (1992-10-15) -& JP 04 184944 A (CITIZEN WATCH CO LTD), 1 July 1992 (1992-07-01)
- PATENT ABSTRACTS OF JAPAN vol. 014, no. 365 (E-0961), 8 August 1990 (1990-08-08) -& JP 02 129933 A (MITSUBISHI ELECTRIC CORP), 18 May 1990 (1990-05-18)

## Description

The invention relates to a device for encapsulating an electronic component, in particular a semiconductor, mounted on a carrier according the preamble of claim 1. The invention also relates to a method for encapsulating an electronic component using such a device.

Encapsulating of electronic components, particularly chips mounted on a lead frame or BGA, takes place on large scale by placing the carrier with electronic component mounted thereon in a mould cavity between two mould parts. Liquid moulding material is then pressed into the mould cavity. The drawbacks of encapsulation according to the prior art arise due to the guiding of the liquid moulding material over the edge of the carrier to a mould cavity situated closer to the middle of the carrier. This entails the danger of moulding material coming into contact with the side of the carrier remote from the mould cavity. This is highly undesirable because this side generally serves for electrical connection of the assembly to the ground. Another drawback is that after the encapsulation the edge of the carrier contains remnants of moulding material, which may be a drawback in further processing of the carrier with encapsulated component. A solution for this latter problem is to provide a part of the edge of the carrier with a layer to which the moulding material does not adhere or does so only very poorly (for instance a gold layer), whereby the moulding material located on the edge after encapsulation can be easily removed. A significant drawback of applying a poorly adhesive layer is that this has a considerable cost increase effect.

The Japanese patent JP 57-128930 discloses a mold construction for transfer molding in which the resin only contacts a substrate at a specified sealed region. Use is made of a plate provided with an aperture (cavity 3) for shielding a part of the substrate from the resin. A runner in the lower mold part leads the resin over the plate to the aperture. The resin in the runner does not touch the substrate so that damage to the substrate is avoided.

The present invention has for its object to provide an improved device and method of the type stated in the preamble, with which an encapsulation can be arranged without the danger of fouling the edge and the side of the carrier remote from the mould cavity and without the drawbacks of the prior art.

The invention provides for this purpose a device for encapsulating an electronic component, in particular a semiconductor, mounted on a carrier, according claim 1. In preference the supply means for moulding material herein connect onto the holder member in order to carry the moulding material over the holder member to the mould cavity. A first advantage of the device according to the invention is that the rigidly linked sleeve of the supply means with the holder member reduces the chance of leakage between supply means and holder member. This applies e.g. for the side of the carrier remote from the mould cavity the danger of fouling is considerably reduced, which is particularly advantageous since this side is generally utilized for electrical connection of the encapsulated component to the ground.

United States Patent US 4,954,308 discloses a resin encapsulating method in which a flat resin circuit board (carrier) with the electronic component mounted thereon is sandwiched between a first mould part and a second mould part wherein the electronic component is disposed within a cavity formed by at least the first mould part, a gate plate (holder member) is arranged on the circuit board, and a resin is filled in said cavity. Said plate having a gate groove to form a side gate. Also form this document it is clear that the gate plate is not rigidly linked with the supply means for resin (e.g. see figure 10A). Furthermore it is not mentioned that the circuit board is urged by the gate plate against one of the mould parts in order to prevent fouling the edge of the circuit board.

In order to define the mould cavity, at least one of the mould parts is preferably provided with a recess. For good operation of the device a passage for moulding material is left clear in an encapsulating position between the holder member and one of the mould parts, which passage extends from the supply means to the mould cavity. The moulding material will hereby be carried from the supply means directly between the holder member and one of the mould parts to the mould cavity. Both holder member and mould parts can take a wear-resistant and easily cleanable form.

For guiding of the moulding material from the supply means to the mould cavity, one of the mould parts can be provided with a runner located on the contact side for passage of moulding material, although it is also possible for the passage for moulding material to be arranged in the holder member. It is also possible to arrange runners in both the holder member and a mould part which connect to each other.

For a mechanized or an automated operation of the device it is necessary that the device be provided with drive means for displacing the mould parts and the holder member relative to each other. The supply means for moulding material can in conventional manner comprise a plunger with which a pellet of moulding material is heated and placed under pressure such that liquid moulding material is guided to the mould cavity.

The invention further provides a method of encapsulating an electronic component, in particular a semiconductor, mounted on a carrier, according claim 8. During step D) the moulding material is herein preferably carried over the holder member to the mould cavity. By applying the method according to this invention the advantages as described above can be realized on the basis of the device according to the invention.

After step D) and after at least partial curing of the moulding material, the counter-mould part is preferably moved back to an opened position and the holder member is displaced to a position in which it releases the carrier. The carrier with encapsulated electronic component can thus be taken out of the device and a carrier with electronic component which is not yet encapsulated can be placed in accordance with step A so that the process can be carried out once again. In order to shorten the cycle time it is possible to perform process steps B and C simultaneously.

The present invention will be further elucidated with reference to the non-limitative embodiment shown in the following figures. Herein:
figure 1 shows a detail view of a cross-section through a device not part of the invention in a fully opened position,
figure 2 shows a detail of the device in cross-section corresponding with that shown in figure 1 in a partly closed position,
figure 3 shows a detail view of the device according shown in figures 1 and 2 in an encapsulating position and
figure 4 shows a detail view of a cross-section through an embodiment of the device according the invention in a fully opened position.

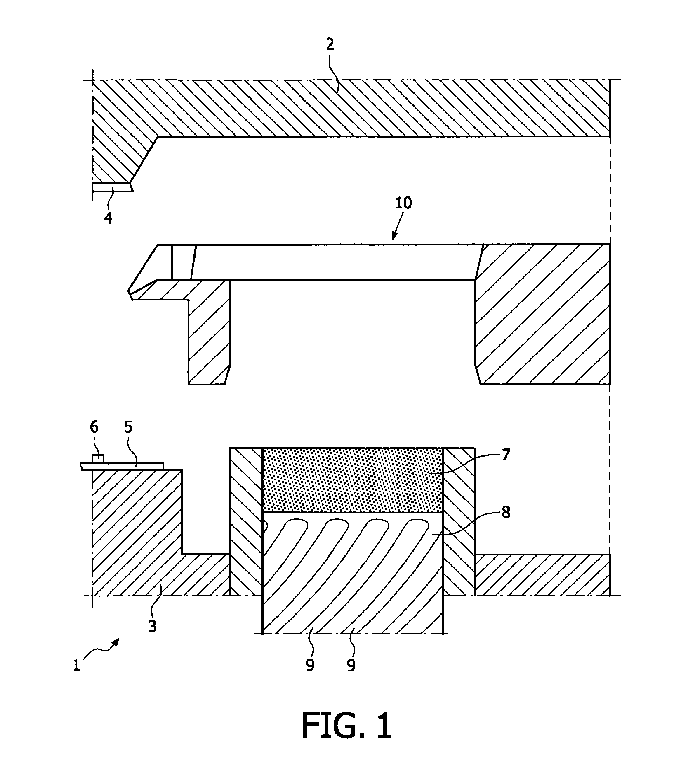

Figure 1 shows a detail of an encapsulating device 1 with an upper mould part 2 and a lower mould part 3 which are placed in moved-apart position. Arranged in upper mould part 2 is a mould cavity 4, which in this figure is only partly shown. In the shown position a carrier 5 in the form of a lead frame, BGA etc. can be placed on lower mould part 3. On carrier 5 is mounted an electronic component 6 which has to be encapsulated.

A pellet of moulding material 7 is placed in an opening arranged for this purpose in lower mould part 3, which pellet rests on the top part of a plunger 8. Helical grooves 9 are arranged in plunger 8.

Situated between upper mould part 2 and lower mould part 3 is a holder member 10. For the sake of clarity holder member 10 is, different from the present invention, shown in this figure such that it is completely clear of lower mould part 3. In the present invention however it will be moved less far upward so that it still remains in contact with lower mould part 3.

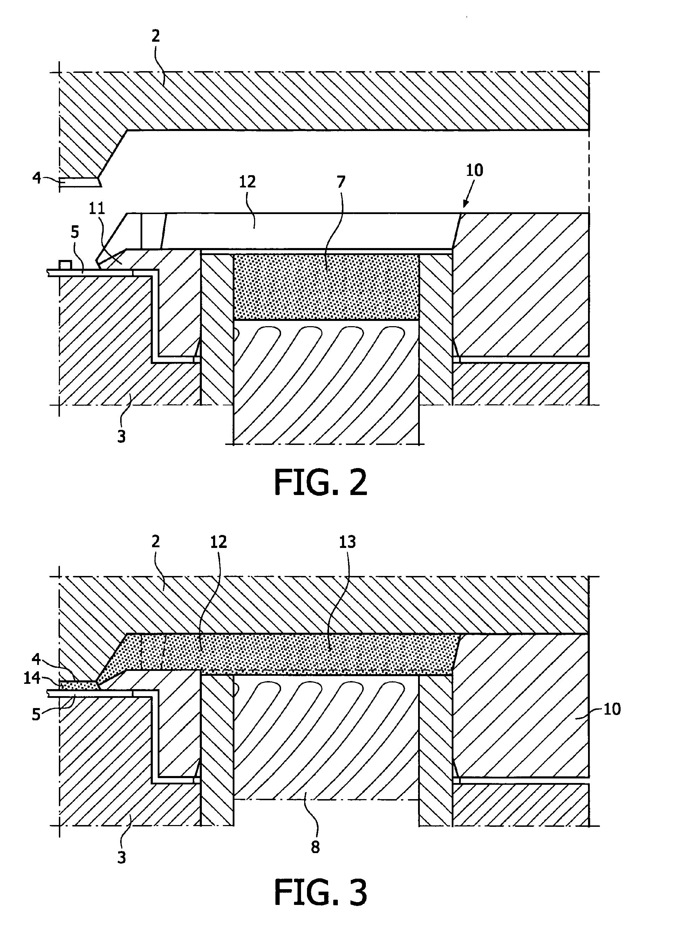

Figure 2 shows the detail of encapsulating device 1 of figure 1 in a position where holder member 10 has been moved so far toward lower mould part 3 that a chamfered outer end 11 thereof engages on an edge of carrier 5. Carrier 5 is hereby clamped between holder member 10 and lower mould part 3. Recessed into holder member 10 is a runner 12 which connects on one side onto the pellet of moulding material 7 and debouches on the other side at carrier 5.

In figure 3 the upper mould part 2 and lower mould part 3 are closed together, wherein mould cavity 4 in upper mould part 2 encloses electronic component 6 on the carrier. After closing of mould parts 2, 3 plunger 8 is displaced in the direction of upper mould part 2, preferably while pellet 7 is simultaneously heated. Liquid moulding material then flows into runner 12 of holder member 10 and into mould cavity 4 A package 14 of moulding material, on which the whole process is focused, is hereby formed on carrier 5. It can clearly be seen here that the injection into mould cavity 4 via runner 12 takes place such that the edge of the carrier remains free of liquid moulding material 13, since the chamfered end 11 of holder member 10 shields the edge of carrier 5.

After at least partial curing of the liquid moulding material 13, mould parts 2, 3 can be moved apart and the cured moulding material in runner 12 can be broken off the package of moulding material 14 on carrier 5. For this purpose the connection of runner 12 to mould cavity 4 is designed such that this separation can be realized without this in any way resulting in an uncontrolled form of the package of moulding material 14.

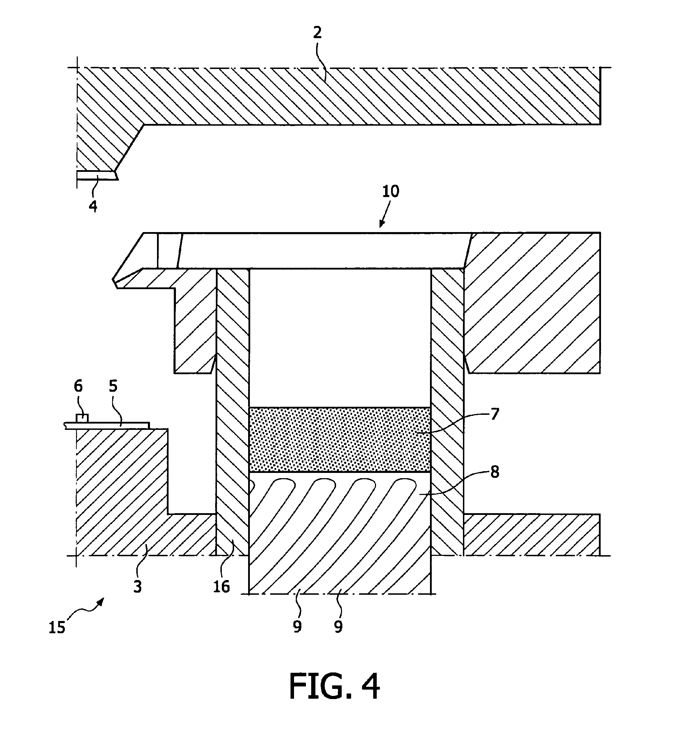

Figure 4 shows a detail of an encapsulating device 15 which shows a great resemblance with the encapsulating device 1 showed in in figure 1. Alternative from figure 1 is a sleeve 16 rigidly linked with the holder member 10 (also referred to as "sleeve holder strip"). The sleeve 16 does move with the holder member 10.

Although the invention is elucidated with reference to only a single embodiment, it will be apparent to all that the invention is in no way limited to the described and shown embodiment. On the contrary, many variations are still possible for the skilled person within the scope of the invention.

## Claims

1. Device (15) for encapsulating an electronic component (6), in particular a semiconductor, mounted on a carrier (5), comprising:
- an upper (2) and a lower mould part (3), which mould parts (2, 3) are displaceable relative to each other between an encapsulating position in which the mould parts (2, 3) take a position enclosing at least one carrier (5) between the mould parts (2, 3) and, connecting onto the enclosed carrier (5), defining at least one mould cavity (4), and an opened position in which the mould parts (2, 3) are situated at a greater mutual distance than in the encapsulating position,
- a holder member (10) displaceable between the mould parts (2, 3) for urging at least an edge part of the carrier (5) against one of the mould parts (2, 3) in the encapsulating position, and
- supply means for feeding liquid moulding material (13) to the mould cavity (4), **characterized in that** the supply means comprise at least a sleeve (16) through which a plunger (8) is able to feed the liquid moulding material (13), the sleeve (16) being rigidly linked with the holder member (10).

2. Device (15) as claimed in claim 1, wherein at least one of the mould parts (2, 3) is provided with a recess defining the mould cavity (4).

3. Device (15) as claimed in any of the foregoing claims, wherein in an encapsulating position a passage for moulding material is left clear between the holder member (10) and one of the mould parts (2, 3), which passage extends from the supply means to the mould cavity (4).

4. Device (15) as claimed in claim 3, wherein one of the mould parts (2, 3) is provided with a runner (12) located on the contact side for defining the passage for moulding material.

5. Device (15) as claimed in claim 4, wherein the runner (12) defining the passage of moulding material connects onto a recess defining the mould cavity (4).

6. Device (15) as claimed in claim 3, wherein the holder member (10) is provided with a runner (12) defining the passage for moulding material.

7. Device (15) as claimed in any of the foregoing claims, wherein the device (15) also comprises drive means for displacing the mould parts (2, 3) between the encapsulating position and the opened position and for displacing the holder member (10).

8. Method of encapsulating an electronic component (6), in particular a semiconductor, mounted on a carrier (5), using a device as claimed in any of the claims 1-7, comprising the steps of:
A) placing the carrier (5) with electronic component (6) mounted thereon on a mould part (2, 3),
B) urging at least an edge part of the carrier (5) against the mould part (2, 3) with a holder member (10) which holder member (10) being rigidly linked to a sleeve (16) of the supply means, through which sleeve (16) a plunger (8) is able to feed the liquid moulding material (13),
C) causing the mould part (2, 3) and holder member (10) to connect onto a counter-mould part (2, 3) such that a mould cavity (4) is created which fits on the carrier (5), and
D) feeding moulding material from the sleeve (16) to the mould cavity (4).

9. Method as claimed in claim 8, wherein during step D) the moulding material is carried over the holder member (10) to the mould cavity (4).

10. Method as claimed in claim 8 or 9, wherein after step D) and after at least partial curing of the moulding material the counter-mould part (2, 3) is moved back to an opened position and the holder member (10) is displaced to a position in which it releases the carrier (5).

11. Method as claimed in any of the claims 8-10, wherein steps B and C are performed simultaneously.

## Patentansprüche

1. Vorrichtung (15) zum Einkapseln einer elektronischen Komponente (6), insbesondere eines auf einem Träger (5) montierten Halbleiters, die besteht aus:
- einem oberen (2) und einem unteren Formteil (3), welche Formteile (2, 3) relativ zueinander verschoben werden können zwischen einer Einkapselungsposition, in der die Formteile (2, 3) eine Position einnehmen, wobei mindestens ein Träger (5) zwischen den Formteilen (2, 3) eingeschlossen wird, sowie der Verbindung mit einem eingeschlossenen Träger (5), wobei mindestens ein Formhohlraum (4) definiert wird, und einer offenen Position, in der die Formteile (2, 3) sich in einem größeren Abstand zueinander befinden als in der Einkapselungsposition,
- einem Halter (10), der zwischen den Formteilen (2, 3) verschiebbar ist, um mindestens ein Randteil des Trägers (5) in der Einkapselungsposition gegen eines der Formteile (2, 3) zu drücken, und
- Zufuhrmittel für die Zufuhr von flüssiger Formmasse (13) in den Formhohlraum (4),
**dadurch gekennzeichnet, dass** die Zufuhrmittel mindestens eine Hülse (16) umfassen, durch die ein Kolben (8) in der Lage ist, die flüssige Formmasse (13) zuzuführen, wobei die Hülse (16) fest mit dem Halter (10) verbunden ist.

2. Vorrichtung (15) nach Anspruch 1, worin mindestens eines der Formteile (2, 3) mit einer Aussparung versehen ist, die den Formhohlraum (4) definiert.

3. Vorrichtung (15) nach einem der vorhergehenden Ansprüche, worin in einer Einkapselungsposition ein Durchlass für Formmasse zwischen dem Halter (10) und einem der Formteile (2, 3) freigelassen wird, welcher Durchlass sich von den Zufuhrmitteln bis zum Formhohlraum (4) erstreckt.

4. Vorrichtung (15) nach Anspruch 3, worin eines der Formteile (2, 3) mit einem Läufer (12) versehen ist, der sich an der Kontaktseite befindet, um den Durchlass für die Formmasse zu definieren.

5. Vorrichtung (15) nach Anspruch 4, worin der Läufer (12), der den Durchlass der Formmasse definiert, mit einer Aussparung, die den Formhohlraum (4) definiert, verbunden ist.

6. Vorrichtung (15) nach Anspruch 3, worin der Halter (10) mit einem Läufer (12) versehen ist, der den Durchlass für Formmasse definiert.

7. Vorrichtung (15) nach einem der vorhergehenden Ansprüche, worin die Vorrichtung (15) auch Antriebsmittel für die Verschiebung der Formteile (2, 3) zwischen der Einkapselungsposition und der offenen Position und zum Verschieben des Halters (10) umfasst.

8. Verfahren zum Einkapseln einer elektronischen Komponente (6), insbesondere eines auf einem Träger (5) montierten Halbleiters, unter Verwendung einer Vorrichtung nach einem der Ansprüche 1 - 7, die die Schritte umfasst:
(A) Legen des Trägers (5) mit den darauf montierten elektronischen Komponenten (6) auf ein Formteil (2, 3),
(B) Drücken von zumindest einem Randteil des Trägers (5) gegen das Formteil (2, 3) mit einem Halter (10), welcher Halter (10) fest mit einer Hülse (16) der Zufuhrmittel verbunden ist, durch welche Hülse (16) ein Kolben (8) in der Lage ist, die flüssige Formmasse (13) zuzuführen,
(C) Bewirken, dass das Formteil (2, 3) und der Halter (10) mit einem Gegenformteil (2,3) derartig verbunden werden, dass ein Formhohlraum (4) geschaffen wird, der auf den Träger (5) passt, und
(D) Zuführen von Formmasse von der Hülse (16) in den Formhohlraum (4).

9. Verfahren nach Anspruch 8, worin während Schritt (D) die Formmasse über den Halter (10) zu dem Formhohlraum (4) befördert wird.

10. Verfahren nach Anspruch 8 oder 9, worin nach Schritt (D) und nach zumindest teilweisem Aushärten der Formmasse das Gegenformteil (2,3) in eine offene Position zurückgebracht wird und der Halter (10) in eine Position verschoben wird, in der er den Träger (5) freigibt.

11. Verfahren nach einem der Ansprüche 8-10, worin die Schritte (B) und (C) gleichzeitig erfolgen.

## Revendications

1. Dispositif (15) pour encapsuler un composant électronique (6), en particulier un semi-conducteur, monté sur un support (5), comprenant :
- une pièce de moule supérieure (2) et une pièce de moule inférieure (3), lesquelles pièces de moule (2, 3) sont déplaçables l'une par rapport à l'autre entre une position d'encapsulation dans laquelle les pièces de moule (2, 3) prennent une position enfermant au moins un support (5) entre les pièces de moule (2, 3) et, par raccordement au support enfermé (5), définissant au moins une cavité de moule (4), et une position ouverte dans laquelle les pièces de moule (2, 3) sont situées à une distance mutuelle plus grande que dans la position d'encapsulation ;
- un organe de maintien (10) déplaçable entre les pièces de moule (2, 3) pour pousser au moins une pièce formant bord du support (5) contre l'une des pièces de moule (2, 3) dans la position d'encapsulation, et
- des moyens d'alimentation pour injecter une matière de moulage liquide (13) dans la cavité de moule (4),
**caractérisé en ce que** les moyens d'alimentation comprennent au moins un manchon (16) à travers lequel un plongeur (8) est apte à injecter la matière de moulage liquide (13), le manchon (16) étant relié rigidement à l'organe de maintien (10).

2. Dispositif (15) selon la revendication 1, dans lequel au moins l'une des pièces de moule (2, 3) est pourvue d'un évidement définissant la cavité de moule (4).

3. Dispositif (15) selon l'une quelconque des revendications précédentes, dans lequel, dans une position d'encapsulation, un passage pour la matière de moulage est laissé dégagé entre l'organe de maintien (10) et l'une des pièces de moule (2, 3), lequel passage s'étend des moyens d'alimentation à la cavité de moule (4).

4. Dispositif (15) selon la revendication 3, dans lequel l'une des pièces de moule (2, 3) est pourvue d'un canal secondaire d'injection (12) situé sur la face de contact pour définir le passage pour matière de moulage.

5. Dispositif (15) selon la revendication 4, dans lequel le canal secondaire d'injection (12) définissant le passage pour matière de moulage se raccorde à un évidement définissant la cavité de moule (4).

6. Dispositif (15) selon la revendication 3, dans lequel l'organe de maintien (10) est pourvu d'un canal secondaire d'injection (12) définissant le passage pour matière de moulage.

7. Dispositif (15) selon l'une quelconque des revendications précédentes, dans lequel le dispositif (15) comprend aussi des moyens d'entraînement pour déplacer les pièces de moule (2, 3) entre la position d'encapsulation et la position ouverte et pour déplacer l'organe de maintien (10).

8. Procédé d'encapsulation d'un composant électronique (6), en particulier d'un semi-conducteur, monté sur un support (5), au moyen d'un dispositif selon l'une quelconque des revendications 1-7, comprenant les étapes consistant :
A) à placer sur une pièce de moule (2, 3) le support (5) comportant le composant électronique (6) y monté ;
B) à pousser au moins une pièce formant bord du support (5) contre la pièce de moule (2, 3) avec un organe de maintien (10), l'organe de maintien (10) étant relié rigidement à un manchon (16) des moyens d'alimentation, manchon (16) à travers lequel un plongeur (8) est apte à injecter la matière de moulage liquide (13) ;
C) à amener la pièce de moule (2, 3) et l'organe de maintien (10) à se raccorder à une pièce de moule opposée (2, 3) de telle sorte qu'une cavité de moule (4) soit créée qui est adaptée au support (5), et
D) à injecter de la matière de moulage depuis le manchon (16) jusqu'à la cavité de moule (4).

9. Procédé selon la revendication 8, dans lequel, durant l'étape D), la matière de moulage est transportée par-dessus l'organe de maintien (10) jusqu'à la cavité de moule (4).

10. Procédé selon la revendication 8 ou 9, dans lequel, après l'étape D) et après durcissement au moins partiel de la matière de moulage, la pièce de moule opposée (2, 3) est ramenée dans une position ouverte et l'organe de maintien (10) est déplacé jusqu'à une position dans laquelle il libère le support (5).

11. Procédé selon l'une quelconque des revendications 8-10, dans lequel les étapes B et C sont exécutées simultanément.
